**Europäisches Patentamt**

**European Patent Office**

(19)

**Office européen des brevets**

(11) Veröffentlichungsnummer : **0 329 722 B1**

(12) **EUROPÄISCHE PATENTSCHRIFT**

(45) Veröffentlichungstag der Patentschrift :
01.04.92 Patentblatt 92/14

(51) Int. Cl.⁵ : **H01L 25/10**

(21) Anmeldenummer : **88905709.7**

(22) Anmeldetag : **16.07.88**

(86) Internationale Anmeldenummer :
**PCT/DE88/00442**

(87) Internationale Veröffentlichungsnummer :
**WO 89/02161 09.03.89 Gazette 89/06**

(54) **GLEICHRICHTEREINRICHTUNG.**

(30) Priorität : **22.08.87 DE 3728081**

(43) Veröffentlichungstag der Anmeldung :
**30.08.89 Patentblatt 89/35**

(45) Bekanntmachung des Hinweises auf die
Patenterteilung :
**01.04.92 Patentblatt 92/14**

(84) Benannte Vertragsstaaten :
**DE FR GB IT**

(56) Entgegenhaltungen :
**DE-A- 2 026 911
DE-A- 2 105 364
FR-A- 2 031 028
US-A- 3 927 338
US-A- 4 606 000**

(73) Patentinhaber : **ROBERT BOSCH GMBH
Postfach 30 02 20
W-7000 Stuttgart 30 (DE)**

(72) Erfinder : **ARMBRUSTER, Franz
Florian-Geyer-Str. 36
W-7000 Stuttgart 31 (DE)**
Erfinder : **BUCK, Hartmut
Amselweg 6
W-7142 Marbach (DE)**
Erfinder : **FASTERDING, Henning
Belringweg 20
W-7145 Markgröningen (DE)**
Erfinder : **PUBRL, Wenzel
August-Lämmle-Str. 25
W-7147 Eberdingen (DE)**
Erfinder : **RENNER, Stefan
Im Wengert 31
W-7251 Weissach-Flacht (DE)**
Erfinder : **KOPLIN, Karl-Heinz
Frankenstr. 26
W-7141 Schwieberdingen (DE)**

## Beschreibung

Die Erfindung geht aus von einer Gleichrichtereinrichtung nach der Gattung des Anspruchs 1. Bekannt sind Gleichrichtereinrichtungen oder-im engeren Sinne-die Anordnung von Kühlkörpern für Gleichrichterdioden bei elektrischen Generatoren in vielfältiger Form, wobei üblicherweise speziell bei Drehstromgeneratoren für die Anwendung bei Kraftfahrzeugen - dies ist ein bevorzugtes Anwendungsgebiet auch vorliegender Erfindung, so daß hierauf genauer eingegangen wird - die jeweiligen Plusdioden und die jeweiligen Minusdioden auf getrennten Trägerblechen angeordnet sind. Die Befestigung der Dioden in den jeweiligen Trägerblechen, die gleichzeitig Kühlkörper für diese sind, erfolgt normalerweise durch Einsetzen in Aufnahmebohrungen der Trägerplatten oder Kühlkörper, wobei die sichere Befestigung durch Einlöten, aber auch durch Einsetzen unter Druck erreicht werden kann. Die Kopfdrähte der Dioden stehen frei nach außen und werden mit Leitungen verbunden, die sich üblicherweise in einer Schaltungsplatte erstrecken bis zu den jeweiligen Anschlußpunkten.

Jeder Diodenkühlkörper ist dabei üblicherweise kreissegmentartig oder halbmondähnlich in seiner Form ausgebildet und ist in der gleichen Ebene wie der andere Diodenkühlkörper randseitig auf der Schaltungsträgerplatte befestigt, in der sich die elektrischen Verbindungsleitungen befinden. Diese Verbindungsleitungen können in das Kunststoffmaterial der Schaltungsträgerplatte eingelegte Drähte, aber auch Blechstanzteile sein. Bekannt ist die Grundform solcher Gleichrichter einrichtungen beispielsweise aus der DE-AS 1 256 303 oder der DE-OS 27 35 124.

Problematisch ist bei der bekannten Bauweise und Lagerung der Kühlkörper auf der einen Seite der Kunststoffschaltungsplatte, daß nur ein beschränkter Raum für die Montage zur Verfügung steht, der für eine Erhöhung der Wärme abgebenden Flächen der Kühlkörper nicht beliebig in radialer Richtung erweitert werden kann, da die Außenabmessungen des Drehstromgenerators durch das Ständerpaket und die beidseitigen Lagerschilde vorgegeben sind.

Ferner ist besonders problematisch die nicht immer absolut stabile und daher wenig schüttelfeste Bauweise, wobei die Vielzahl der Gleichrichterdioden, beispielsweise vier Minusdioden und vier Plusdioden, wenn man den Sternpunkt ebenfalls verbindet, zusätzlich zu den üblichen drei Erregerdioden auf dem engen, zur Verfügung stehenden Raum zu lagern und anzuschließen sind. Auch die sichere Kontaktierung zwischen den Anschlüssen der Leiterplatte und den Dioden sowie zwischen den Ständerdrähten und der Leiterplatte ist problematisch.

Betrachtet man die bei der Herstellung von Drehstromgeneratoren für Kraftfahrzeuge erforderlichen Arbeiten, dann ist insbesondere umständlich, daß die Ständerdrähte, die nach dem Einwickeln der Ständerwicklungen in die Ständernuten an beliebiger Stelle enden, in verschiedene Richtungen gebogen werden mußten, so daß sie mit ihren Endbereichen zu den Orten geführt werden konnten, wo der Anschluß zur Leiterplatte erfolgt. Schließlich werden dort die Ständerdrähte im Sternpunkt separat miteinander verbunden und auf die herausgeführten Ständerdrähte einzeln Isolierschläuche aufgefädelt.

Entsprechendes gilt auch für eine Gleichrichtereinrichtung nach der FR-A-2 031 028, wobei die Ständerdrähte an sogenannten Lötstützpunkten eines zwischen den Diodenplatten angeodneten Isolators mit Anschlußleitungen für jeweils zwei Dioden in entsprechend geformte Ausnehmungen des Isolators miteinander verbunden werden müssen. Der Sternpunkt ist dabei separat im Wickelkopf der Maschine verschaltet.

Aus der US-A-4 606 000 ist schließlich eine Gleichrichtereinrichtung für Drehstromlichtmaschinen nach der Gattung des Patentanspruchs 1 bekannt, bei der zwischen den zwei Dioden-Trägerplatten sandwichartig eine dünne Isolierplatte eingefügt ist, um die beiden als Kühlkörper wirkenden Trägerplatten voneinander elektrisch zu isolieren, den Wärmeaustausch sowie die Wärmeabführung durch einen Kühlluftstrom dabei möglichst nicht zu behindern. Die Dioden liegen dabei auf zwei konzentrischen Teilkreisen und werden paarweise über separate elektrische Anschlüsse mit den Ständerdrähten kontaktiert, wobei die Anschlußleiter ihrerseits jeweils in separate Tragkörper aus Isolierstoff oberhalb der Trägerplatte aufgenommen sind. Auch diese Lösung ist wegen ihrer vielen, separat herzustellenden Teile sehr aufwendig und benötigt insbesondere durch die separaten Tragkörper für die Anschlußschienen einen relativ großen Einbauraum.

Der vorliegenden Erfindung liegt die Aufgabe zugrunde, sowohl Aufbau als auch die Montagevorgänge bei der Herstellung eines solchen Gleichrichters durch eine spezielle Kompaktbauweise drastisch zu vereinfachen und ihn hierdurch insbesondere auch schüttelfester und stabiler zu machen.

Vorteile der Erfindung

Die Erfindung löst die genannte Aufgabe mit den kennzeichnenden Merkmalen des Anspruchs 1. Das hat den Vorteil, daß durch einen speziellen Aufbau der als Leiterplatte ausgestalteten Isolierplatte mit sandwichartig zu beiden Seiten axial angeordneten Trägerplatten für die Gleichrichterdioden eine schüttelfeste, stabile und insbesondere auch kompakte Bauweise für die Gleichrichteranordnung insgesamt erzielt ist, die als Ganzes außen am zugeordneten Lagerschild des Drehstromgenerators montiert werden kann und durch eine eigene kappenförmige Schutzhaube abzudecken ist.

Besonders vorteilhaft ist, daß durch den sandwichartigen Aufbau, bei dem die Trägerplatten oder Kühlkörper für die Dioden auf beiden Seiten der Leiterplatte praktisch den gesamten zur Verfügung stehenden radialen Raum einnehmen können, gute Kühlwirkungen zu erzielen sind; die Packungsdicke ist wesentlich geringer, und die Kopfdrähte oder Anschlußdrähte der Dioden sind dann von beiden Seiten zur innen liegenden Leiterplatte geführt und dort mit den entsprechenden, aus dem Kunststoffmaterial der Leiterplatte herausragenden bzw. freiliegenden Anschlüssen verbunden.

Dennoch baut die erfindungsgemäße Gleichrichtereinrichtung in axialer Richtung, in welcher eine erste Dioden-Trägerplatte, die Leiterplatte und die zweite Diodenträgerplatte aufeinanderfolgend geschichtet sind, auffallend kurz, denn durch einander gegenüberliegende Durchbrechungen in den jeweiligen Diodenträgerplatten oder Kühlkörpern finden die Kopfdrähte der in der gegenüberliegenden Diodenträgerplatte angeordneten Dioden hinreichend Platz und können, obwohl sie zu der jeweils anderen Diodenträgerplatte gehören, auf der Seite der dann jeweils einen Diodenträgerplatte, da sie über deren Trägerfläche hinausschauen und insoweit auch zugänglich sind, durch geeignete weitere Bearbeitungsgänge mit den Anschlüssen der Leiterplatte verbunden, üblicherweise gelötet oder widerstandsgeschweißt werden.

Dabei ist auch vorteilhaft, daß der jeweilige Diodenkühlkörper (Pluskühlkörper oder Minuskühlkörper) eine radiale Ausdehnung aufweisen kann, die praktisch, bis auf den Ausschnitt für die Bürstenhalterung, der gesamten Kreisfläche des Drehstromgenerators entspricht, so daß wegen der entscheidend verbesserten Kühlung mit erheblich höheren Strömen gearbeitet werden kann, so daß nicht nur eine Vereinfachung im Bereich der Gleichrichtereinrichtung erzielt, sondern auch der gesamte Funktionsablauf des Drehstromgenerators erheblich verbessert werden kann.

Von besonderem Vorteil ist ferner, daß das Einbringen der Leitungen in die das Zwischenteil zwischen den beiden Diodenkühlkörpern bildenden Kunststoffleiterplatte nunmehr mittels eines Einlegeautomaten vorgenommen werden kann, da nicht mehr einzelne Leitungen gebildet sind, sondern ein zusammenhängendes, komplettes Stanzgitter von insgesamt in etwa halbkreisförmiger Flächenerstreckung die erforderlichen Leitungsverbindungen innerhalb der Kunststoffleiterplatte nachbildet und von deren Material umspritzend aufgenommen ist.

Da dieses einheitliche komplette Stanzgitter natürlich zunächst für sämtliche Leitungsanschlüsse einen Kurzschluß bilden würde, wird die entsprechende Aufteilung der Leitungsverbindungen dadurch vorgenommen, daß die Durchtrennung der vier Phasen und der Erregerstromschiene mittels einer Stanztrennung im Spritzwerkzeug erfolgt.

Durch die Stanzgitterform der Leitungen, die aus einer vollflächigen Halbkreisblechform herausgestanzt wird, werden eine Vielzahl von sonst erforderlichen Arbeitsgängen für die Herstellung der einzelnen Leitungsverbindungen eingespart, wobei durch die Verwendung des Stanzgitters die Erregerdioden, Leistungsdioden und Ständerdrähte mit den vom Stanzgitter angebotenen Anschlüssen widerstandsgeschweißt werden können.

Ein weiterer Vorteil vorliegender Erfindung besteht darin, daß die vom Ständer ausgehenden Drahtanschlüsse der Ständerwicklung sämtlich nach oben geführt und von der Leiterplatte aufgenommen werden können, also auch die Anschlüsse, die bei üblicher Drehstromgeneratorauslegung den Sternpunkt der hier vorhandenen drei Phasen bilden. Die Verschaltung sämtlicher, mit dem Sternpunkt dann vier Phasen U, V und W sowie die Einbindung einer integrierten Erregerdioden-Stromschiene erfolgt dann über das Stanzgitter innerhalb der Leiterplatte, wobei auch der Sternpunkt innerhalb der Leiterplatte gebildet wird, also eine gesonderte Verschaltung und Verbindung von Ständerleitungen außerhalb der Leiterplatte nicht mehr erforderlich ist.

Dabei ist die Leiterplatte innerhalb der beidseitigen Diodenkühlkörper so ausgebildet, daß von dieser köcherartige oder rohrförmige Erstreckungen ausgehen, die beim Befestigen der gesamten Gleichrichtereinrichtung am Drehstromgenerator unmittelbar bis zu den Stellen geführt sind, wo nach dem Wickeln jeweilige Ständerdrahtenden als Drahtanschlüsse vorhanden sind. Diese Köcher der Leiterplatte nehmen dann diese Ständerdrähte auf, die senkrecht, also ohne die Notwendigkeit irgendwelcher Abbiegungen, zur zugehörigen Schweißfahne der Leiterplatte geführt werden. Dabei dienen diese Köcher an der Leiterplatte gleichzeitig als Isolierung zwischen dem B-Lagerschild (schleifringseitigem Lagerschild) und den Ständerdrähten, denn bei vorliegender Erfindung wird die Gleichrichtereinrichtung von außen auf das B-Lagerschild aufgesetzt und anmontiert, welches unmittelbar über einen Einpaß das Ständerpaket auf der einen Seite aufnimmt.

In diesem Zusammenhang bereitet es dann keine weitere Mühe mehr, die erforderlichen, nach außen zu führenden Anschlüsse, beispielsweise die Anschlüsse D+ und W in Bolzenform direkt am Stanzgitter anzuschweißen oder dieses entsprechend auszubilden.

Schließlich besteht eine weitere bevorzugte Ausgestaltung vorliegender Erfindung darin, daß zur Erzielung einer sicheren Kontaktierung zwischen den Leiterplattenanschlüssen und den Dioden sowie zwischen den Ständerdrähten und den Leiterplattenanschlüssen die jeweiligen, vom Stanzgitter in der Leiterplatte gebildeten Anschlußenden U-förmig ausgebildet und angebogen sind. In diese U-Form werden dann ein oder zwei Diodendrähte bzw. die Anschlüsse vom Ständer (U, V, W und die Sternpunktanschlüsse) eingelegt und anschließend durch weiteres Umbiegen und Zupressen der U-Form der Anschlußkontaktierung, also durch Vercrimpen gesichert und geschweißt.

Vorteilhafte Weiterbildungen und Verbesserungen der erfindungsgemäßen Gleichrichtereinrichtung sind ferner möglich durch die in den Unteransprüchen aufgeführten Maßnahmen.

Zeichnung

Ausführungsbeispiele der Erfindung sind in der Zeichnung dargestellt und werden in der nachfolgenden Beschreibung näher erläutert. Es zeigen:

Fig. 1 in einer mit Bezug zu den anderen Darstellungen vergrößerten Form die Trägerplatte bzw. den Kühlkörper für die Plusdioden (Pluskühlkörper) in Draufsicht,

Fig. 2 eine Draufsicht auf die Leiterplatte bei weggenommenem Pluskühlkörper und

Fig. 3 eine Ansicht von unten auf den Minuskühlkörper so, wie dieser dem B-Lagerschild zugewandt ist, auf welchem er aufliegt;

Fig. 4 einen Schnitt längs der Linie IV-IV der Fig. 3;

Fig. 5 einen Schnitt längs der Linie V-V der Fig. 1 bzw. V-V der Fig. 2 mit dem Diodenkopfdraht nach unten;

Fig. 6 eine Teildarstellung längs der Linie VI-VI der Fig. 1, mit Fragmenten des B-Lagerschildes und

Fig. 7 eine mögliche Ausführungsform eines bei der Spritzgußherstellung der Leiterplatte in deren Form einzulegenden Stanzgitters vor der Herstellung der Unterbrechungen in Draufsicht.

Beschreibung der Ausführungsbeispiele

Der Grundgedanke vorliegender Erfindung besteht darin, sandwichartig und hier speziell von außen nach innen des Drehstromgenerators gesehen, in axialer Abfolge den Pluskühlkörper, die Leiterplatte und den Minuskühlkörper anzuordnen, die sandwichartig gestapelten Bauteile miteinander zu verbinden und als Gleichrichtereinheit dem Drehstromgenerator zuzuordnen, vorzugsweise von außen an das B-Lagerschild anzusetzen und anzuschrauben.

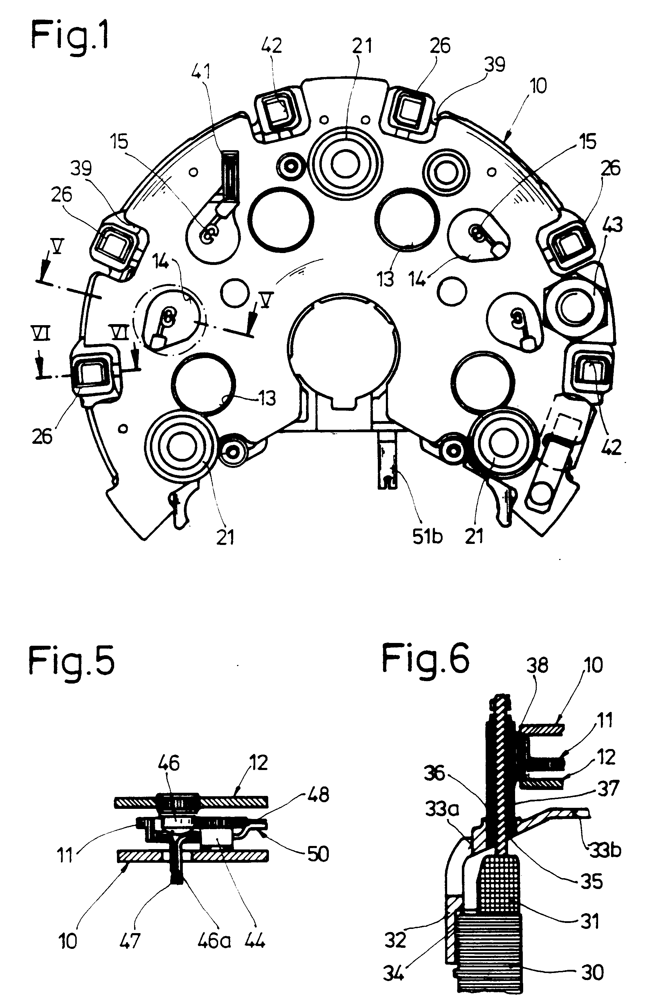

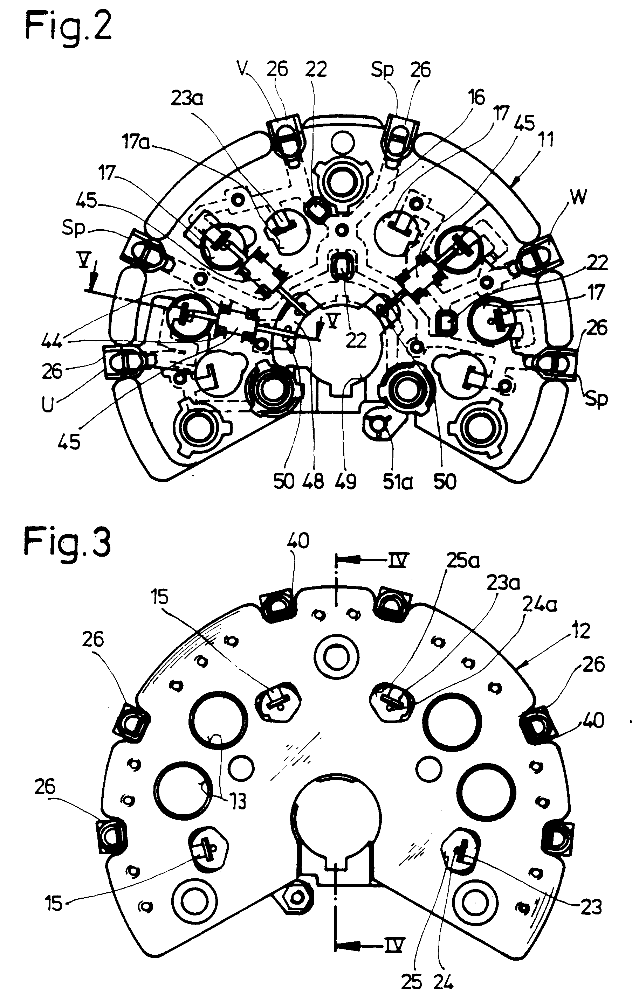

In Fig. 1 ist der die Form einer Trägerplatte aufweisende Pluskühlkörper mit 10 bezeichnet, er befindet sich oberhalb der von ihm im wesentlichen verdeckten, jedoch durch Ausschnitte im Pluskühlkörper in einigen Teilen erkennbaren Leiterplatte, die in Fig. 2 gezeigt und mit 11 bezeichnet ist. In gleicher Weise ist der sich dann unterhalb der Leiterplatte befindende Minuskühlkörper mit 12 bezeichnet; die beiden Kühlkörper weisen jeweils primäre Bohrungen 13 auf, zur Aufnahme der in sie eingesetzten Gleichrichterdioden von üblicher Form, wobei das metallische Diodengehäuse jeweils den einen Anschlußpol der Diode und der Kopfdraht den anderen bildet. Dies ist bekannt, und hierauf braucht nicht weiter eingegangen zu werden.

Da, wie erwähnt, der Pluskühlkörper 10 und der Minuskühlkörper 12 gegeneinander gerichtet mit dazwischenliegender Leiterplatte 11 angeordnet sind, sind auch die von den in die jeweiligen Kühlkörper eingesetzten Dioden ausgehenden Kopfdrähte sowohl von beiden Seiten auf die Leiterplatte 11 als auch, da sie durch Durchbrechungen hindurchtreten, auf den jeweils gegenüberliegenden anderen Kühlkörper gerichtet. Um hier einen freien Durchtritt zu ermöglichen und um insbesondere die erforderlichen elektrischen Anschlüsse und Kontaktierungen mit den Leiterfahnen oder Anschlußenden der Leiterplatte selbst vorzunehmen, die von der Leiterplatte ausgehen, weisen daher Pluskühlkörper 10 und Minuskühlkörper 12 weitere Hauptdurchbrechungen 14 auf, die dem Durchtritt der Kopfdrähte der jeweils gegenüberliegenden Diode dienen sowie der entsprechenden zugeordneten Anschlußfahne der Leiterplatte und natürlich auch dazu, einen Kurzschluß mit der jeweils entgegengesetzten Polarität des betreffenden Kühlkörpers insgesamt zu vermeiden. Der Pluskühlkörper und der Minuskühlkörper liegen daher praktisch aufeinander mit der dazwischenliegenden Leiterplatte und durchdringen mit den Kopfdrähten jeweils gegenüberliegende Bohrungen im anderen Kühlkörper; durch diese Bohrungen sind im übrigen auch die jeweils herzustellenden Anschlüsse, die wieder einheitlich mit 15 bezeichnet sind, gut zu erkennen.

Zur Gewinnung eines besseren Überblicks wird im folgenden zunächst auf Aufbau und Form der zwischen den beiden Kühlkörpern angeordneten Leiterplatte 11 anhand der Darstellung der Fig. 2 genauer eingegangen.

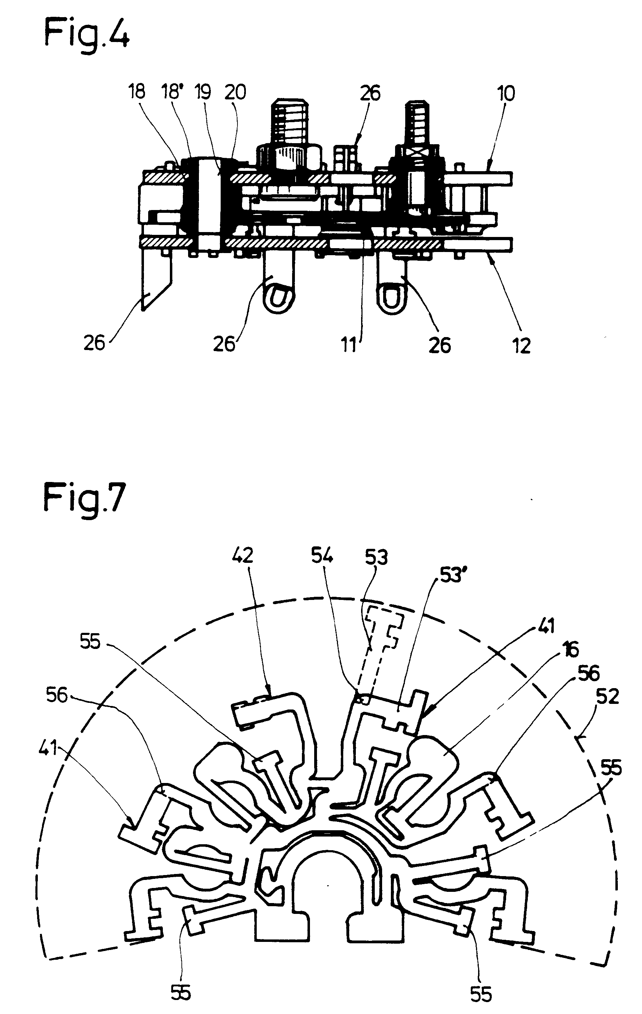

Die Leiterplatte 11 besteht aus einem plattenförmigen Grundkörper von einer eine Halbkreisform nur geringfügig übersteigenden Fläche mit einem in der Zeichenebene unteren segmentartigen Ausschnitt - hier findet dann der an das B-Lagerschild angebaute Bürstenhalter Platz. Die Leiterplatte 11 besteht aus isolierendem Kunststoff und in ihr eingelagert, d.h. von ihrem Kunststoffmaterial umspritzt ist eine aus einem geeigneten, elektrisch leitenden Metall bestehendes Stanzgitter, welches mit 16 bezeichnet ist. Eine mögliche Ausführungsform eines solchen Stanzgitters 16 ist in Fig. 7 nochmals genauer dargestellt - hierauf wird weiter unten eingegangen.

Da das Stanzgitter 16, welches aus einer geeigneten Kreisblechform (MS-Blech) ausgestanzt ist, jedenfalls zum Zeitpunkt des Einlegens in die Spritzgußform für die Herstellung der Leiterplatte noch einstückig ist, kann das Stanzgitter von einem Einlegeautomaten in die Form eingebracht werden, ohne daß es manueller Eingriffe bedarf.

Das Kunststoffmaterial der Leiterplatte umgibt dann die Grundform des Stanzgitters mit den Leitungsverbindungen vollkommen, wobei Öffnungen bzw. Durchlässe 17 in beliebiger Form, beispielsweise kreisrund oder Teilkreisausschnitte, offen bleiben, durch welche elektrische Anschlüsse bildende Stanzblechenden des Stanzgitters austreten. Diese Endanschlüsse sind dann entweder nach oben oder unten gebogen, bezogen auf die Zeichenebene der Fig. 2, d.h. in Richtung auf den Pluskühlkörper 10 oder den Minuskühlkörper 12 bzw. den Ständerdrähten folgend.

Wie die Querschnittform der Fig. 4 zeigt, weist die Leiterplatte an bestimmten Stellen vorzugsweise nach beiden Seiten sich erweiternde hülsenartige Verdickungen 18 auf, die der Abstandshalterung zwischen den beiden Kühlkörpern 10 und 12 dienen und gleichzeitig dazu bestimmt sind, durch an dieser Stelle angeordnete Hohlnieten 19 eine feste Verbindung der Sandwichform aus Pluskühlkörper 10, Leiterplatte 11 und Minuskühlkörper 12 herzustellen. Man erkennt im übrigen in der Darstellung der Fig. 4, daß die Nietverbindung 19 am Minuskühlkörper 12 ohne Zwischenlage anliegt, während durch eine sich verjüngende Ringabstandshalterung 18' und eine isolierende Beilegscheibe 20 dafür gesorgt ist, daß der aus dem Pluskühlkörper 12 austretende obere Nietkopf gegenüber diesem isoliert ist. Von diesen Querverbindungen können eine vorgegebene Anzahl zur Erzielung einer hinreichenden Stabilität vorgesehen sein; wie die Darstellung der Fig. 1 zeigt, sind insgesamt drei Querverbindungen 21 gebildet, jeweils durch Hohlnietverbindungen 19.

In der Darstellung der Fig. 2 erkennt man das in der Leiterplattenform befindliche Stanzgitter 16, welches gestrichelt dargestellt ist. Um die erforderlichen Leitungstrennungen zu erzielen, werden die das Stanzgitter bildenden, einen beliebigen Kurvenverlauf aufweisenden Flachblechbänder an vorgegebenen Stellen durch einen weiteren Stanzvorgang unterbrochen; diese Stellen sind in Fig. 2 mit 22 bezeichnet. Das Aufschneiden der Leitungen in der Leiterplatte erfolgt vorzugsweise durch Stanztrennung im Spritzwerkzeug, da dann die nunmehr abgetrennten Leitungen innerhalb der Kunststofform der Leiterplatte sicher gehalten und positioniert bleiben.

Der weitere Montagevorgang ist problemlos erkennbar; verbindet oder legt man nämlich zunächst den Pluskühlkörper der Fig. 1 mit den in die Öffnungen 13 eingepreßten vier Plusdioden auf die Leiterplatte der Fig. 2, um mit einem Arbeitsgang zu beginnen, und dreht das Ganze dann um, dann erkennt man, daß die Kopfdrähte der Plusdioden an den vorgegebenen Stellen, deren Verteilung, wie es sich versteht, durchaus beliebig ist (daher sind im übrigen die dargestellten Strukturen, Bohrungsabstände, Grundformen und Leitungsführungen als für die Erfindung nicht einschränkend zu verstehen), in die Durchbrüche 17 der Leiterplatte hineinragen, praktisch angrenzend an die sich in diesen Durchbrüchen ebenfalls befindenden und schon in die entsprechende Richtung, hier auf den Minuskühlkörper 12 abgebogenen Blechanschlußfahnen der Leitungen. In Fig. 3 ist zum besseren Verständnis einer dieser Anschlußkontakte oder eine dieser Anschlußfahnen mit 23 und der dazugehörige, mit diesem Anschluß zu verbindende Kopfdraht einer Plusdiode mit 24 bezeichnet. Diese beiden elektrischen Anschlußverbindungen (Diodenkopfdraht und Anschlußfahne) sind auch durch eine entsprechende Ausnehmung, die in Fig. 3 speziell mit 25 bezeichnet ist, im Minuskühlkörper 12 erkennbar und treten auch durch diese Ausnehmung um einen vorgegebenen Abstand hervor, wie dies an anderer Stelle bei 26 in Fig. 4 gezeigt ist. Es ist daher möglich, durch diese Öffnung 25 in dem einen Kühlkörper, der auf die jeweilige Einpreßdiodenöffnung im anderen Kühlkörper ausgerichtet ist - daher sind die jeweiligen Bohrungen für die Aufnahme der Dioden in den beiden Kühlkörpern zueinander versetzt -, die Verbindung der beiden Anschlüsse vorzunehmen, beispielsweise durch Widerstandsschweißen oder auch einen vorhergehenden Klemmvorgang (Crimpen), was weiter unten noch erläutert wird.

Dies wiederholt sich bei allen Montagevorgängen, wobei in Fig. 2 lediglich eine der abgebogenen Anschlußfahnen mit 23a bezeichnet ist, die in Fig. 3 (spiegelbildlich) wieder auftritt, zusammen mit dem Kopfdraht 24a der zugehörigen Plusdioden, die vom Pluskühlkörper 10 kommend zunächst die entsprechende Öffnung 17a in der Leiterplatte durchsetzen und dann die Öffnung 25a in dem gegenüberliegenden Kühlkörper, also dem Minuskühlkörper 12 in diesem Fall.

In einer weiteren Ausgestaltung vorliegender Erfindung sind der Peripherie der Leiterplatte folgend bzw. längs der Peripherie vorzugsweise einstückig mit der Leiterplatte ausgebildete Führungsmittel für die von dem Ständer kommenden Anschlußdrähte vorgesehen.

Bei der vorliegenden Erfindung, bei der der Sternpunkt innerhalb der Leiterplatte von den dort verlaufenden Leitungen (Flachblechbändern) gebildet wird, sind bei einem Drehstromgenerator bei drei Phasenwicklungen also sechs elektrische Anschlußdrähte vom Ständer ausgehend zu übernehmen. Diese Führungsmittel der Leiterplatte können und sind bevorzugt an den Örtern längs der Leiterplattenperipherie angeordnet, an denen entsprechend Wicklungsart und Beginn und Ende jeder der Phasenwicklungen die Anschlußdrähte der Phasenwicklung tatsächlich am Ständer auftreten, so daß es nicht erforderlich ist, solche Ständerdrähte noch in verschiedene Richtungen zu biegen. Die Führungsmittel sind bevorzugt in Form von von der Leiterplatte nach unten in Richtung auf den Ständer ausgehende Hohlrohre, die im folgenden als Köcher bezeichnet werden, ausgebildet und reichen bei dem hier dargestellten Ausführungsbeispiel bis durch entsprechende Durchlässe im B-Lagerschild angrenzend zu den Wicklungspaketen des Ständers.

In den Figuren sind diese Führungsköcher für die Ständerdrähte mit 26 bezeichnet, wobei der grundlegende Mechanismus anhand der vergrößerten Detailausschnittsdarstellung der Fig. 6 erläutert wird. In Fig. 6 ist das aus geschichtetem Eisenblech bestehende Ständerpaket mit 30, eine der Phasenwicklungen mit 31 bezeichnet. Man erkennt, daß das B-Lagerschild 32 mit Lüftungsöffnungen 33a und 33b das Ständerpaket in einem Einpaß 34 übernimmt, wobei der von der jeweiligen Phasenwicklung 31 ausgehende Ständeranschlußdraht mit 35 bezeichnet ist. Dieser Anschlußdraht 35 geht geradlinig nach oben ab und wird praktisch unmittelbar über der Phasenwicklung 31 und noch vor Durchtritt durch eine entsprechende Durchtrittsöffnung 36 im B-Lagerschild 32 vom Köcher 37 aufgenommen, der, wie gut erkennbar, einstückig mit der Leiterplatte 11 ausgebildet ist und sich angrenzend am äußeren Umfang einer Verdickung 38 der Leiterplatte befindet, die als beidseitige Auflage für den Pluskühlkörper 10 und den Minuskühlkörper 12 dient, die lediglich angedeutet sind. Die Verdickung 38 braucht nicht notwendigerweise umlaufend am Umfang der Leiterplatte ausgebildet zu sein, sondern beschränkt sich vorzugsweise auf die schmalen Bereiche im Umfang der Leiterplatte, an denen die Köcher 37 gebildet sind. Auf diese Weise ergibt sich auch eine gute Durchlüftung und ein freies Passieren der in das Innere des Drehstromgenerators angesaugten Kühlluft.

Bezüglich der Kühlluftführung sei noch bemerkt, daß bei dem bevorzugten Ausführungsbeispiel eines Drehstromgenerators, zu welchem die erfindungsgemäße Ausführungsform der Gleichrichtereinrichtung gehört, unmittelbar angrenzend beidseitig zum Ständerpaket und noch innerhalb des vom A-Lagerschild und B-Lagerschild gebildeten Gehäuses die drehangetriebenen Ventilatorräder angeordnet sind, so daß durch die Gleichrichterlagereinrichtung wie beschrieben die Kühlluft nach innen zum Ständerpaket geführt und dort radial, nämlich durch die Kühlluftöffnungen 33a wieder nach außen abgeführt wird. Man erkennt, daß sich auf diese Weise eine besonders gute Kühlung der großflächigen Plus- und Minuskühlkörper 10 and 12 sowie der dazwischen liegenden Lagerplatte 11 ergibt.

Zusammen mit den in die Köcher 26 hineinragenden Ständeranschlußdrähten 35 befinden sich in jedem Köcher die Anschluß- oder Kontaktlaschen der jeweiligen Leitungen aus dem Stanzgittermaterial, wie am besten der Darstellung der Fig. 2 entnommen werden kann. Gestrichelt ist erkennbar, daß entsprechende Leitungsverbindungen in Form der hier bevorzugten Flachblechbänder bis zu den peripheren Bereichen der Leiterplatte 11 geführt sind, an denen die Köcher 26 angesetzt sind, und dann, nach Austritt aus dem Material der Leiterplatte innerhalb der Köcher in diesem Fall nach oben, also in Richtung auf den Pluskühlkörper 10 abgebogen sind.

Die Darstellung der Fig. 1 zeigt, daß der Pluskühlkörper 10 im Bereich der von der Lagerplatte ausgehenden Köcher periphere Ausnehmungen 39 aufweist, die den Durchtritt der Köcher erlauben; das gleiche trifft für den Minuskühlkörper 12 zu, wo solche peripheren Durchbrechungen oder Ausnehmungen mit 40 bezeichnet sind. Dabei stehen die jeweiligen Anschlußlaschen von den Stanzgitter-Leitungen und die Ständerdrähte - dies trifft im übrigen auch auf die mit den Diodenkopfdrähten zu verbindenden Anschlußlaschen zu - über das Ende der Köcherführung und damit auch über die obere Fläche in diesem Falle des Pluskühlkörpers 10 hinaus, wie am besten der Darstellung der Fig. 6 entnommen werden kann, so daß sich hier eine leichte Zugänglichkeit für die weiteren Verbindungsschritte (sichere Kontaktierung zwischen den Anschlußdrähten oder Kopfdrähten und den Anschlußlaschen) ergibt.

Hier setzt eine weitere, sehr bevorzugte Ausführungsform vorliegender Erfindung ein, die darin besteht, zur Erzielung einer besonders sicheren, schüttelfesten und stabilen Kontaktierung zwischen den Leiterplattenanschlüssen und den Dioden sowie zwischen den Leiterplattenanschlüssen (Stanzgitter-Anschlußlaschen) und den Ständerdrähten schon am Stanzgitter 16, wie in Fig. 7 gezeigt, die Anschlußenden allgemein hammerartig, wie bei 41 gezeigt, auszubilden, so daß es möglich ist, diese Anschlußenden zu einer U-Form anzubiegen, wie dies bei 42 in Fig. 7 gezeigt ist. In diese U-Form, die sich besonders deutlich auch den mit dem gleichen Bezugszeichen 42 bezeichneten Anschlußenden in Fig. 1 entnehmen läßt, werden dann, je nach den Erfordernissen der elektrischen Verschaltung, ein oder zwei Diodendrähte bzw. die Ständeranschlußdrähte U, V und W sowie die zum Sternpunkt zusammenzufassenden Ständeranschlußdrähte eingelegt; anschließend wird die U-Form zugedrückt, also vercrimpt und verschweißt, vorzugsweise durch Widerstandsschweißung.

Sämtliche dieser Arbeiten können beispielsweise für die Anschlußverbindungen der Minusdioden (vom Minuskühlblech 12 herrührend und die entsprechenden Durchtrittsöffnungen 14 im Pluskühlkörper 10 durchsetzend) sowie für die sechs Ständeranschlußdrähte von außen vorgenommen werden, nachdem die gesamte Gleichrichtereinrichtung auf das Drehstromgeneratorgehäuse (B-Lagerschild 32) aufgesetzt ist, da diese Kontaktverbindungen frei zugänglich sind.

Um die Gleichrichtereinrichtung insgesamt am B-Lagerschild des Drehstromgenerators zu befestigen, können die Hohlnietenführungen 21, die zunächst der Befestigung der Sandwichform untereinander aus Plus- und Minuskühlkörper und Leiterplatte gedient haben, als Durchtrittsbohrungen für Verschraubungen verwendet werden, die dann in entsprechende Gewindeöffnungen der B-Lagerplatte eingesetzt und verschraubt werden. Es versteht sich, daß man auf diese Weise problemlos zu den B-Anschlüssen und den B+ Anschlüssen für den Drehstromgenerator gelangt, indem man entsprechende Verschraubungen oder Steckanschlüsse am Pluskühlkörper oder Minuskühlkörper vorsieht. Solche Anschlüsse sind in Fig. 1 insgesamt mit 43 bezeichnet; das gleiche gilt für einen der Phasenanschlüsse (W-Anschluß) etwa für Drehzahlbestimmung u. dgl.

Eine besonders umständliche und üblicherweise stets gesondert durchzuführende, zu montierende und zu lagernde Anordnung ist die Plazierung der sogenannten Erregerdioden und deren D+ Anschlußschiene; auch dieses Problem wird durch die vorliegende Erfindung in besonders einfacher und vorteilhafter Weise gelöst.

Zur Lagerung der kleineren, etwa zylinderförmig ausgebildeten Erregerdioden dienen halteklammerartige Vorsprünge 44, vorzugsweise einstückig ausgebildet an der Leiterplatte 11, wie dies am besten der Darstellung der Fig. 2 in Verbindung mit der Fig. 5 entnommen werden kann, die allerdings umgedreht gezeichnet ist, also mit obenliegendem Minuskühlkörper 12.

In die sich scherenartig öffnenden Halteklammern oder Vorsprünge 44 an der Leiterplatte 11 werden die Erregerdioden 45 (s. Fig. 2) eingeklipst, wobei der eine Anschlußdraht, wie Fig. 5 zeigt, mit dem Kopfdraht 46a einer Minusdiode 46 und einer entsprechenden Anschlußlasche 47 der Stanzgitterform zusammengeführt, mit dieser vercrimpt und verschweißt ist. Der andere Anschluß läuft bei dem bevorzugten dargestellten Ausführungsbeispiel von außen nach innen zur hier in etwa kreisförmig verlaufenden D+ Schiene 48, die ebenfalls als Teil des Stanzgitters hier allerdings nur soweit längs des inneren runden Ausschnittes 49 in der Leiterplatte 11 eingelagert ist, daß bestimmte Stellen der D+ Schiene 48 frei bleiben, nämlich dort, wo die anderen Anschlußdrähte der Erregerdioden 45 angeschweißt oder sonstwie verbunden sind, wie in Fig. 2 bei 50 gezeigt. Auf diese Weise ergibt sich an einem nach außen geführten Teil der D+ Schiene der Anschluß D+, der in Fig. 2 als Schraubanschluß ausgebildet und mit 51a und in Fig. 1 als Steckanschluß ausgebildet und mit 51b bezeichnet ist.

Eine weitere bevorzugte Ausgestaltung vorliegender Erfindung liegt darin, daß zur Herstellung der Stanzgitterform entsprechend Fig. 7 normalerweise, nämlich bei den hier vorhandenen sechs Phasenanschlüssen U, V und W sowie die Sternpunktanschlüsse sechs Anschlußenden des Stanzgitters längs des peripheren Umfangs der Leiterplatte 11 hergestellt und umgebogen werden müssen, so daß sich normalerweise eine Ausgangsblechform mit dem in Fig. 7 gestrichelt dargestellten Umriß 52 als notwendig erweist. Bei einer solchem im Umfang vergleichsweise großen Blechform können dann die äußersten Anschlußenden, von denen einer in Fig. 7 mit 53 gestrichelt dargestellt ist, etwa längs der Knickstelle 54 nach oben (bzw. nach unten) umgebogen werden, so daß sich dann die erforderliche dreidimensionale Stanzgitterform ergibt - die verschiedenen Anschlußenden für die Herstellung der Verbindungen mit den Diodenkopfdrähten sind in der Darstellung der Fig. 7 mit 55 bezeichnet.

Da die Erfindung erkannt hat, daß es unerheblich ist, ob die U-Form der Anschlußlaschen zur Kontaktierung in Umfangsrichtung geöffnet sind oder radial nach innen oder außen blicken, wie dies in Fig. 1 der Fall ist, werden die äußeren Anschlußenden mit den hammerartigen Verbreiterungen zur Bildung der U-Form abgebogen im Stanzgitter 16 angeordnet, also allgemein in peripherer Richtung, wodurch sich, wie leicht bei 53′ erkennbar, ein wesentlich kleinerer Umriß und daher auch eine geringere Materialmenge ergibt. Wesentlich ist dann lediglich, daß die Abbiegungen der Anschlußenden längs Linien 56 erfolgen. Auch auf diese Weise gelingt es, die Anschlußenden der Stanzgitterform mit den U-förmigen Kontakten senkrecht zur Zeichenebene in der dreidimensionalen Form anzuordnen.

Um wenigstens angenähert auch auf ein praktisches Verschaltungsbeispiel einzugehen, sind in der Darstellung der Fig. 2 die einzelnen vom Ständer kommenden Drähte noch in ihrer elektrischen Zuordnung bezeichnet, also die Phasenanschlüsse U, V, W bzw. die zum Sternpunkt geführten Anschlußdrähte Sp.

**Patentansprüche**

1. Gleichrichtereinrichtung für Drehstrom-Generatoren, insbesondere für Kraftfahrzeuge, Busse, Bahnen und sonstige mobile Einheiten, die mit je einer Plus- und Minus-Dioden (45,46) aufnehmenden Trägerplatte (10,12) versehen ist, wobei jede der als Pluskühlkörper (10) und Minuskühlkörper (12) ausgebildeten Trägerplatten für die Gleichrichterdioden (45,46) sich über eine Fläche erstreckt, die der Kreisform des Generators angenähert einen Teilkreis umfaßt, die beiden Kühlkörper (10,12) in axialem Abstand zueinander in getrennten Ebenen gleichachsig angeordnet sind sowie eine Isolierplatte (11) zwischen den Kühlkörpern sandwichartig aufgenommen ist, dadurch gekennzeichnet, daß im Material der als Leiterplatte ausgestalteten Isolierplatte (11), die der Verschaltung der Dioden untereinander und mit den Ständerdrähten dienenden Leitungen eingebettet sind und daß die von einem der Kühlkörper (10,12) aufgenommenen Gleichrichterdioden (45, 46) mit ihren jeweiligen Kopfdrähten (45, 46a) durch entsprechende Durchbrechungen (17, 14, 25) in der Leiterplatte (11) und im anderen Kühlkörper (12, 10) auf diesen gegenüberliegenden anderen Kühlkörper (12,10) ausgerichtet sind.

2. Gleichrichtereinrichtung nach Anspruch 1, dadurch gekennzeichnet, daß die Kühlkörper (10,12) erste Bohrungen (13) zur Aufnahme der Dioden (im Preßsitz oder gelötet) und Durchbrechungen (14; 25, 25a) aufweisen zum kontaktfreien Durchtritt von je einem der Kopfdrähte am jeweils gegenüberliegenden Kühlkörper gemeinsam mit je einem der Anschlußenden (Flachblech-Anschlußlaschen 53′) der Leitungskonfiguration (Stanzgitter 16) in der Leiterplatte (11).

3. Gleichrichtereinrichtung nach einem der Ansprüche 1 oder 2, dadurch gekennzeichnet, daß die Leiterplatte (11) zur Abstandshalterung der beiden auf ihren gegenüberliegenden Flächen angeordneten Plus- und Minuskühlkörper (10,12) an vorgegebenen Stellen Abstandshülsen (18) bildende Verdickungen aufweist, die ferner so ausgebildet sind, daß zur Isolierung der beiden Kühlkörper gegeneinander jede Abstandshülse einen Isolierhülsenfortsatz (18′) aufweist und daß durch diese Abstandshülsenkonfiguration Verbindungsmittel (Hohlnieten 19) geführt sind, deren Nietenkopf durch eine isolierende Beilegscheibe (20) gegen einen der Kühlkörper isoliert ist.

4. Gleichrichtereinrichtung nach einem der Ansprüche 1 - 3, dadurch gekennzeichnet, daß die von einem Stanzgitter in der Leiterplatte (11) herrührenden Anschlußenden aus der Leiterplattenebene nach unten und oben, jeweils in Richtung zu einem der beidseitig angeordneten, die Dioden tragenden Kühlkörper (Pluskühlkörper 10, Minuskühlkörper 12) umgebogen und an Orten angeordnet sind, an denen sich die Diodenkopfdrähte bzw. vom Ständer hochgeführte Ständeranschlußdrähte befinden.

5. Gleichrichtereinrichtung nach Anspruch 4, dadurch gekennzeichnet, daß im Stanzgitter (16) mit den Diodenkopfdrähten und/oder den Ständeranschlußdrähten zu verbindende Anschlußenden als U-Form ausgebildet sind, in welche Diodendrähte und Ständeranschlußdrähte eingelegt, vercrimpt sowie verschweißt oder verlötet werden.

6. Gleichrichtereinrichtung nach einem der Ansprüche 1 - 5, dadurch gekennzeichnet, daß von den Ständerphasenwicklungen (31) herrührende Ständeranschlußdrähte (35) vorzugsweise an der Stelle, wo sie aus den Ständerwicklungen austreten, in Richtung auf die Gleichrichtereinrichtung geführt und mit den entsprechenden Anschlußenden der Leitungen in der Leiterplatte (11) verbunden sind.

7. Gleichrichtereinrichtung nach einem der Ansprüche 1 - 6, dadurch gekennzeichnet, daß die Leiterplatte (11) über ihren Umfang verteilt (einstückige) hohlrohrförmige Führungen (Führungsköcher 26) aufweist, die in Durchbrechungen mindestens eines der angrenzenden Kühlkörper (10,12) bis vor die Phasenwicklungen (31) des Ständerpakets (30) geführt sind, zur isolierten Aufnahme und Führung der von den Phasenwicklungen ausgehenden Ständerdrähte (35) unter Verzicht auf Isolierschläuche und Abbiegungen bis zu den Anschlußenden (Kontaktlaschen 42) der Leiterplatte 11.

8. Gleichrichtereinrichtung nach Anspruch 7, dadurch gekennzeichnet, daß die Führungsköcher (26) für die Ständerdrähte (35) durch bzw. längs entsprechender Ausnehmungen aus der dem Ständerpaket (30) gegenüberliegenden obersten Kühlkörperplatte (Pluskühlkörper 10) geführt sind, und daß die dort anzuschließenden (U-förmigen) Enden der Leitungen der Leiterplatte (11) und der Ständerdrähte (35) über die Fläche des oberen Kühlkörpers (Pluskühlkörper 10) hinausragen, zur Durchführung des Verbindungsvorgangs (Widerstandsschweißen).

9. Gleichrichtereinrichtung nach einem der Ansprüche 1 - 8, dadurch gekennzeichnet, daß in Rastmitteln (44) der Leiterplatte (11) Erregerdioden (45) eingeklipst sind, wobei die einen Anschlußdrähte der Erregerdioden zu einer gemeinsamen in der Leiterplatte (11) fixierten D+ Schiene geführt und mit dieser verbunden sind, und die einen nach außen gerichteten Anschluß D+ (51a, 51b) aufweist.

10. Gleichrichtereinrichtung nach einem der Ansprüche 1 - 9, dadurch gekennzeichnet, daß die Sandwichform aus Pluskühlkörper (10), Leiterplatte (11) und Minuskühlkörper (12) von außen auf das zugewandte Lagerschild (B-Lagerschild 32) des Drehstromgenerators aufgesetzt und befestigt ist, wobei die die Ständerdrähte aufnehmenden und führenden Köcher (26) der Leiterplatte (11) durch Durchtrittsöffnungen (36) in dem zugewandten Lagerschild bis angrenzend zur jeweiligen Phasenwicklung, aus der der Ständerdraht ohne Abbiegungen austritt, geführt sind.

11. Gleichrichtereinrichtung nach einem der Ansprüche 1 - 10, dadurch gekennzeichnet, daß die außen am Lagerschild (32) befestigte Sandwichform aus Kühlkörpern und Leiterplatte vom in Inneren des Drehstromgenerators beidseitig zum Ständerpaket angeordneten Ventilatorrändern angesaugten Luftstrom gekühlt ist.

12. Gleichrichtereinrichtung nach einem der Ansprüche 1 - 11, dadurch gekennzeichnet, daß die Anschlußenden jeder Stanzgitterleitung in der Grundform hammerartig mit seitlichen Erstreckungen ausgebildet sind zur späteren Anbiegung in eine U-Kontaktlaschenform zur Aufnahme der jeweiligen Dioden- und Ständerdrähte, mit nachfolgendem Vercrimpen und Verschweißen.

## Claims

1. Rectifier device for three-phase generators, particularly for motor vehicles, buses, railways and other mobile units, which is provided in each case with a supporting board (10, 12) holding positive and negative diodes (45, 46), each of the supporting boards, designed as positive cooling body (10) and negative cooling body (12), for the rectifier diodes extending over a surface which comprises an arc approximating to the circular shape of the generator, the two cooling bodies (10, 12) being arranged at an axial distance from one another, in separate planes on a common axis, and an insulating board (11) being held between the cooling bodies in the manner of a sandwich, characterised in that the lines which are used for connecting the diodes to one another and to the stator wires are embedded in the material of the insulating board (11), which is designed as a printed-circuit board, and in that the rectifier diodes (45, 46) held by one of the cooling bodies (10, 12), together with their respective head wires (45, 46a), are aligned with this other, opposite cooling body (12, 10) by means of corresponding cut-outs (17, 14, 25) in the printed-circuit board (11) and in the other cooling body (12, 10).

2. Rectifier device according to Claim 1, characterised in that the cooling bodies (10, 12) have first holes (13) for holding the diodes (in a press-fit or soldered) and cut-outs (14; 25, 25a) for the passage, without making contact, of in each case one of the head wires on the respectively opposite cooling body, together with in each case one of the terminal ends (flat sheet-metal terminal lugs 53′) of the line configuration (stamped grid 16) in the printed-circuit board (11).

3. Rectifier device according to one of Claims 1 or 2, characterised in that the printed-circuit board (11) has thickened regions forming spacer sleeves (18) at predetermined points for maintaining the separation of the two positive and negative cooling bodies (10, 12) arranged on its opposite surfaces, which are further designed such that each spacer sleeve has an insulating sleeve projection (18′) for mutual insulation of the two cooling bodies, and in that through this spacer sleeve configuration there are guided connecting means (hollow rivets 19), whose rivet head is insulated with respect to one of the cooling bodies by means of an insulating washer (20).

4. Rectifier device according to one of Claims 1 - 3, characterised in that the terminal ends originating from a stamped grid in the printed-circuit board (11) are bent upwards and downwards out of the printed-circuit board plane, in each case in the direction of one of the cooling bodies (positive cooling body 10, negative cooling body 12) which are arranged on both sides and support the diodes, and are arranged at points at which the diode head wires and stator connecting wires guided up from the stator are located.

5. Rectifier device according to Claim 4, characterised in that terminal ends which are to be connected in the stamped grid (16) to the diode head wires and/or to the stator connecting wires are designed in a U-shape into which diode wires and stator connecting wires are inserted, crimped and welded or soldered.

6. Rectifier device according to one of Claims 1 - 5, characterised in that stator connecting wires (35) originating from the stator phase windings (31) are guided in the direction of the rectifier device, preferably at the point where they emerge from the stator windings, and are connected to the corresponding terminal ends of the lines in the printed-circuit board (11).

7. Rectifier device according to one of Claims 1 - 6, characterised in that the printed-circuit board (11) has (one-piece) hollow tubular guides (guide cases 26) distributed around its circumference, which are guided in cut-outs of at least one of the adjacent cooling bodies (10, 12) up to the phase windings (31) of the stator stack (30), for the insulated retention and guidance of the stator wires (35) originating from the phase windings, while dispensing insulating hoses and bends up to the terminal ends (contact lugs 42) of the printed-circuit board 11.

8. Rectifier device according to Claim 7, characterised in that the guide cases (26) for the stator wires (35) are guided through or along corresponding recesses out of the uppermost cooling body board (positive cooling body 10) opposite the stator stack (30), and in that the (U-shaped) ends, to be connected there, of the lines of the printed-circuit board (11) and of the stator wires (35) project over the surface of the upper cooling body (positive cooling body 10) in order to carry out the connecting process (resistance welding).

9. Rectifier device according to one of Claims 1 - 8, characterised in that exciter diodes (45) are clipped into latching means (44) of the printed-circuit board (11), some of the connecting wires of the exciter diodes being guided to a common D+ rail, fixed in the printed-circuit board (11), and being connected thereto, and which D+ rail has an outwardly directed terminal D+ (51a, 51b).

10. Rectifier device according to one of Claims 1 - 9, characterised in that the sandwich shape, consisting of the positive cooling body (10), the printed-circuit board (11) and the negative cooling body (12), is placed and mounted from the outside on the facing bearing plate (B-bearing plate 32) of the three-phase generator, the cases (26), which guide and retain the stator wires, of the printed-circuit board (11) being guided through openings (36) in the facing bearing plate until they are adjacent to the respective phase winding from which the stator wire emerges, without bends.

11. Rectifier device according to one of Claims 1 - 10, characterised in that the sandwich shape, which is mounted externally on the bearing plate (32) and consists of the cooling bodies and the printed-circuit board, is cooled by the air flow which is sucked in [lacuna] ventilator edges arranged inside the three-phase generator on both sides of the stator stack.

12. Rectifier device according to one of Claims 1 - 11, characterised in that the terminal ends of each stamped grid line are designed, in terms of the basic shape, in the manner of hammers with extensions along the sides, for subsequent bending into a U-contact lug shape for holding the respective diode and stator wires, with subsequent crimping and welding.

**Revendications**

1. Dispositif redresseur pour générateurs de courant triphasé, en particulier pour véhicules, automobiles, autobus, trains et autres unités mobiles, qui est pourvu de plaques support (10, 12) recevant chacune une diode plus et une diode moins (45, 46), dans lequel chacune des plaques support constituée comme corps (10) de refroidissement plus et corps (12) de refroidissement moins pour les diodes (45, 46) du redresseur s'étend sur une surface, qui épouse approximativement la forme circulaire du générateur, et comprend un arc de cercle, les deux corps de refroidissement (10, 12) étant disposés selon le même axe à une certaine distance axiale l'un de l'autre dans des plans séparés et une plaque isolante (11) étant montée à la manière d'un sandwich entre les deux corps de refroidissement, dispositif redresseur caractérisé en ce que dans la matière de la plaque isolante (11) constituée comme une carte de circuits imprimée, les conducteurs servant au montage des diodes les uns dans les autres et au raccordement aux fils du stator sont noyés et en ce que les diodes (45, 46) du redresseur reçues dans l'un des corps de refroidissement (10, 12) sortent par leurs fils de tête correspondants (45, 46a) à travers les ouvertures correspondantes (17, 14, 25) dans la carte de circuits imprimée (11) et sont orientées dans l'autre corps de refroidissement (12, 10) vers cet autre corps de refroidissement (12, 10) situé en face.

2. Dispositif redresseur selon la revendication 1, caractérisé en ce que les corps de refroidissement (10, 12) présente des premiers perçages (13) pour recevoir les diodes (en étant enfoncées à la presse sur leur siège ou soudées) et des ouvertures (14 ; 25 ; 25a) pour un passage, libre de tout contact, de chaque fois l'un des fils de tête sur le corps de refroidissement situé en regard en même temps qu'avec chaque fois l'une des extrémités de connexion (barrettes de connexion 53′ en tôle plate) de la configuration des conducteurs (grille estampée 16) dans la carte de circuits imprimée (11).

3. Dispositif redresseur selon la revendication 1 ou 2, caractérisé en ce que la carte de circuits imprimée (11) présente pour maintenir l'écartement des deux corps de refroidissement plus et corps de refroidissement moins (10, 12) disposés sur les surfaces se faisant vis-à-vis aux endroits prédéfinis, présente des surépaisseurs formant douilles d'écartement (18), qui en outre sont constituées de telle façon que, pour isoler les deux corps de refroidissement l'un de l'autre, chaque douille d'écartement présente un prolongement de douille isolante (18′) et en ce que grâce à cette configuration à douilles d'écartement, on fait passer des moyens de liaison (rivets tubulaires (19), dont la tête de rivet est isolée par une rondelle de calage isolante (20) par rapport à l'une des corps de refroidissement.

4. Dispositif redresseur selon l'une des revendications 1-3, caractérisé en ce que les extrémités des connexions venant en contact depuis une grille estampée dans la carte de circuits imprimée (11) à partir du plan de la carte de circuits imprimée vers le bas et vers le haut, sont recourbées chacune dans le sens allant vers l'un des corps de refroidissement disposé des deux côtés, portant les diodes (corps 10 de refroidissement plus, corps 12 de refroidissement moins) et sont disposées aux endroits où se trouvent les fils de tête des diodes ou les fils de raccordement au stator passant par le haut à partir du stator.

5. Dispositif redresseur selon la revendication 4, caractérisé en ce que, dans la grille estampée (16) sont constituées des extrémités de connexion en forme d'U à relier aux fils de tête des diodes et/ou aux fils de connexion au stator, extrémités dans lesquelles les fils de diode et les fils de connexion au stator sont noyés, sertis et soudés ou brasés.

6. Dispositif redresseur selon l'une des revendications 1 à 5, caractérisé en ce que les fils de connexion au stator (35) provenant des enroulements de phases du stator (31) sont amenés de préférence à l'endroit où ils sortent des enroulements de stator, dans le sens allant au dispositif redresseur et sont reliés avec les extrémités de connexion correspondantes des conducteurs dans la carte de circuits imprimée (11).

7. Dispositif redresseur selon l'une des revendications 1 à 6, caractérisé en ce que la carte de circuits imprimée (11) présente des guides en forme de tubes creux (manchons tubulaires de guidage 26) (d'une seule pièce) répartis sur son pourtour, qui viennent dans des ouvertures d'au moins l'un des corps de refroidissement adjacent (10, 12) jusque devant les enroulements des phases (31) du paquet de tôles du stator (30), pour recevoir et guider de façon isolante les fils de stator (35) partant des enroulements de phase, en évitant des tubes isolants et des coudes jusqu'aux extrémités de connexion (barrettes de contact 42) de la carte de circuits imprimée (11).

8. Dispositif redresseur selon la revendication 7, caractérisé en ce que les manchons tubulaires de guidage (26) pour les fils de stator (35) sont amenés à travers ou le long d'évidements correspondants à partir de la plaque de refroidissement supérieure (corps 10 de refroidissement plus) située en regard du paquet de tôles du stator (30) et en ce que les extrémités des conducteurs de la carte de circuits imprimée (11) et des fils de stator (35) qui doivent être raccordées à cet endroit font saillie au-dessus de la surface du corps de refroidissement supérieur (corps 12 de refroidissement plus), pour l'exécution du procédé de liaison (soudage électrique par résistance).

9. Dispositif redresseur selon l'une des revendications 1 à 8, caractérisé en ce que des diodes d'excitatrice (45) sont encliquetées dans des moyens à crans d'arrêt (44) de la carte de circuits imprimée (11), les fils de connexion des diodes excitatrices étant amenés à une barre D+ comme fixée dans la carte de circuits imprimée (11) et étant reliés à celle-ci et qui présente une connexion D+ (51a, 51b) dirigée vers l'extérieur.

10. Dispositif redresseur selon l'une des revendications 1 à 9, caractérisé en ce que la forme sandwich se composant du corps (10) de refroidissement plus, de la carte de circuits imprimée (11) et du corps (12) de refroidissement moins est monté de l'extérieur sur le flasque (flasque B 32) tourné vers elle du générateur de courant triphasé et fixé sur ce flasque, tandis que les manchons tubulaires (26) de la carte de circuits imprimée (11) recevant les fils du stator et les guidant sont amenés par des orifices de passage (36) dans le flasque tourné vers eux jusqu'au' voisinage de l'enroulement de phase correspondant, à partir duquel le fil de stator soit sort sans faire de couches.

11. Dispositif redresseur selon l'une des revendications 1 à 10, caractérisé en ce que la forme sandwich fixée extérieurement sur le flasque (32) se composant des corps de refroidissement et de la carte de circuits imprimée est refroidie par un courant d'air aspiré par les roues d'un ventilateur disposé à l'intérieur du générateur de courant triphasé des deux côtés du paquet de tôles du stator.

12. Dispositif redresseur selon l'une des revendications 1 à 11, caractérisé en ce que les extrémités des connexions de chaque conducteur de la grille estampée dans la forme de base sont façonnées à la manière de marteaux avec des extensions latérales pour une courbure ultérieure donnant la forme d'une barrette de contact en U pour recevoir les fils correspondants des diodes et du stator, avec ensuite un sertissage et un soudage.

# Fig.1

# Fig.5

# Fig.6

## Fig.2

## Fig.3

# Fig.4

# Fig.7